**Europäisches Patentamt**

**European Patent Office**

**Office européen des brevets**

(11) Numéro de publication: **0 045 691**
**A2**

(12) # DEMANDE DE BREVET EUROPEEN

(21) Numéro de dépôt: **81401233.2**

(22) Date de dépôt: **30.07.81**

(51) Int. Cl.³: **H 03 F 3/50**
**H 03 F 1/52**

(30) Priorité: **31.07.80 FR 8016918**

(43) Date de publication de la demande:
**10.02.82 Bulletin 82/6**

(84) Etats contractants désignés:
**DE FR GB IT NL**

(71) Demandeur: **THOMSON-CSF**
**173, Boulevard Haussmann**
**F-75360 Paris Cedex 08(FR)**

(72) Inventeur: **Lachenal, Jean-Louis**
**THOMSON-CSF SCPI 173, bld Haussmann**
**F-75360 Paris Cedex 08(FR)**

(74) Mandataire: **Guilguet, Philippe et al,**
**"THOMSON-CSF" - SCPI 173, bld Haussmann**
**F-75360 Paris Cedex 08(FR)**

(54) **Etage de sortie basse impédance pour couplage capacitif ou direct.**

(57) La présente invention concerne un étage de sortie basse impédance pour couplage capacitif ou direct.

Cet étage de sortie est constitué d'un transistor en émetteur-suiveur (T) polarisé par une source de courant (T3). Cette source de courant est traversée par un courant I sensiblement égal à n fois le courant $I_O$ d'une source de courant de référence en cas de couplage capacitif avec une charge (R). Si le couplage avec la charge (R) est résistif, un ensemble de transistors (T4, T5, T6) fait que le courant de base vers le transistor (T3) est annulé et la polarisation du transistor (T) se fait directement par la charge résistive.

Application aux étages de sortie de circuits amplificateurs de puissance d'étages vidéo.

Fig.3

## ETAGE DE SORTIE BASSE IMPEDANCE POUR COUPLAGE
## CAPACITIF OU DIRECT.

La présente invention concerne un étage de sortie à basse impédance pour couplage capacitif ou direct avec une charge.

Parmi les divers dispositifs connus pouvant servir d'étage de sortie à basse impédance de circuit amplificateur, on peut citer les étages push-pull à transistors complémentaires. Dans de tels circuits, deux transistors complémentaires, à savoir un transistor NPN et un transistor PNP sont disposés en série. On peut ainsi obtenir sur couplage capacitif à la sortie une tension positive ou négative. Néanmoins, dans le domaine des circuits intégrés, la réalisation des transistors PNP est parfois délicate et exige de recourir à des circuits plus ou moins complexes et de toute manière l'utilisation d'un transistor PNP intégré limite la bande passante.

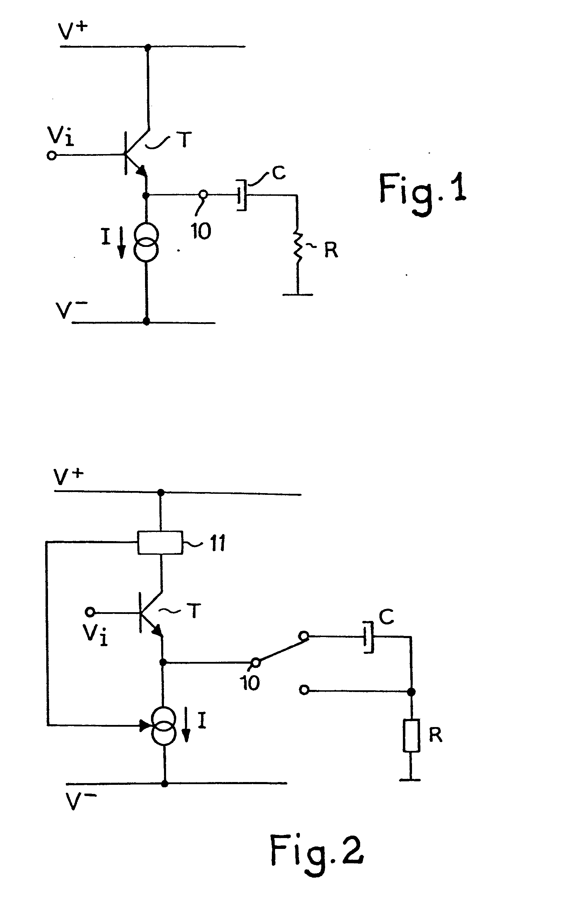

Un autre montage classique pour un étage de sortie basse impédance consiste à utiliser un circuit émetteur-suiveur polarisé par un générateur de courant. Un tel circuit émetteur-suiveur est représenté très schématiquement en figure 1. Ce circuit est connecté entre une borne d'alimentation positive $V^+$ et une tension de référence $V^-$. Un transistor T, généralement NPN, reçoit un signal d'entrée $V_1$, provenant généralement d'autres étages amplificateurs et préamplificateurs d'un circuit complexe. Le collecteur du transistor T est relié à la tension d'alimentation positive et son émetteur est relié à la tension de référence par l'intermédiaire d'une source de courant I. On obtient ainsi une polarisation convenable au niveau de la borne de sortie 10 du circuit de sorte que, quand un couplage avec une charge R est réalisé par l'intermédiaire d'une capacité C, on peut obtenir une excursion négative ou positive de la tension alternative aux bornes de la charge à condition que I soit supérieur à $V_C/R$, $V_C$ étant la tension de crête alternative que l'on souhaite pouvoir obtenir aux bornes de la charge R.

Dans le cas où un circuit tel que celui de la figure 1

2

est utilisé pour un couplage direct sur une charge résistive, c'est-à-dire dans le cas de la figure 1 si le condensateur C est supprimé, la consommation de l'étage de sortie devient importante étant donné qu'au courant I circulant dans la source de courant s'ajoute le courant continu circulant dans la charge résistive. Dans le cas où le courant continu circulant dans la résistance R, en cas de couplage direct, devient supérieur à la valeur de crête du courant alternatif susceptible de passer dans cette charge, il n'est plus nécessaire de prévoir une polarisation de l'émetteur du transistor émetteur-suiveur T. Non seulement cette polarisation est non nécessaire mais en plus elle devient nuisible. En effet, la consommation de courant de l'étage de sortie devient alors égale à la somme du courant I du générateur de courant plus le courant continu circulant dans la charge. Il en résulte une consommation excessivement importante de l'étage de sortie qui peut nuire au bon fonctionnement du circuit intégré et obliger à prendre des précautions importantes en ce qui concerne l'encapsulation de celui-ci pour permettre l'évacuation thermique.

Ainsi, un objet de la présente invention est de prévoir un étage de sortie basse impédance du type à émetteur-suiveur pour couplage capacitif ou direct, dans lequel une polarisation du transistor émetteur-suiveur soit assurée dans le cas d'un couplage capacitif et dans lequel cette polarisation soit arrêtée en cas de couplage direct avec circulation de courant continu dans la charge.

Un autre objet de la présente invention est de prévoir un tel circuit qui soit simplement réalisable sous forme de circuit intégré.

Pour atteindre ces objets ainsi que d'autres, la présente invention prévoit un étage de sortie à circuit émetteur-suiveur polarisé par un générateur de courant, comprenant des moyens pour interrompre l'action du générateur de courant quand le circuit de charge extrait un courant continu de valeur supérieure à un seuil prédéterminé. Les moyens pour interrompre l'action du générateur de courant comprennent des moyens pour comparer un courant de référence à un courant divisé se trouvant dans un rapport de division déterminé par rapport au courant continu dans le circuit de charge et pour commander le générateur de courant seulement quand le courant de référence est supérieur au courant divisé. Le générateur de courant est constitué d'un transistor en série avec l'émetteur du circuit émetteur-suiveur, la base de ce transistor recevant un courant par l'intermédiaire d'un autre transistor seulement quand celui-ci est à l'état passant. Le courant divisé peut être obtenu en choisissant comme émetteur-suiveur un circuit constitué d'un premier et d'un second transistor à bases communes et à émetteurs communs, la surface d'émetteur du premier transistor étant n fois plus petite que celle du second d'où il résulte que le courant de collecteur du premier transistor reflète le courant d'émetteur de l'ensemble des premier et second transistors avec un facteur diviseur de n. Dans ce cas, le circuit comprendra en outre un cinquième et un sixième transistors connectés en miroir de courant, leurs émetteurs étant reliés à la borne d'alimentation positive, de même que le collecteur du deuxième transistor. Le collecteur du sixième transistor est connecté au collecteur du premier transistor, à l'émetteur du quatrième transistor servant à la commande du troisième transistor générateur de courant et à la cathode d'une première diode. Le collecteur du cinquième transistor est connecté à sa base, à l'anode de la première diode et à l'anode d'une deuxième diode. La cathode de la deuxième diode est reliée à la base du quatrième transistor et à une source de courant de référence.

Selon un autre mode de réalisation, le transistor émetteur-suiveur peut être constitué d'un transistor unique dont le collecteur est relié à une source de tension d'alimentation par l'intermédiaire d'une première résistance et dont l'émetteur est connecté à un générateur de courant constitué d'une deuxième transistor. La base de ce deuxième transistor est connectée à la première résistance par l'intermédiaire d'un troisième transistor. Un quatrième transistor est connecté par son émetteur à la source d'alimentation négative avec interposition d'une seconde résistance de valeur n fois plus grande que la première, par sa base à son collecteur et à la base du troisième transistor, et par son collecteur, à une source de courant de référence. Cette source de courant de référence est choisie pour être n fois plus petite que la valeur du courant de sortie de l'émetteur-suiveur dans la charge pour laquelle on ne souhaite plus que le générateur de courant fournisse de courant de polarisation.

Ces objets, caractéristiques et avantages ainsi que d'autres de la présente invention seront exposés plus en détail en relation avec les figures jointes parmi lesquelles :

la figure 1 rappelle la structure d'un étage de sortie du type émetteur-suiveur polarisé par un générateur de courant et a été décrite précédemment ;

la figure 2 représente schématiquement et sous forme de blocs un circuit selon la présente invention ;

la figure 3 représente un premier mode de réalisation d'un étage de sortie selon la présente invention ;

la figure 4 représente un deuxième mode de réalisation d'un étage de sortie selon la présente invention.

Dans les diverses figures, on utilisera autant que faire se peut les mêmes références pour désigner des éléments identiques ou ayant les mêmes fonctions.

Dans la figure 2, on retrouve certains éléments du circuit de la figure 1 à savoir la tension d'alimentation $V^+$, la tension de référence $V^-$, le transistor émetteur-suiveur T, la tension de commande $V_i$, la source de courant I, la charge R, le condensateur de couplage C et la borne de sortie 10 connectée à l'émetteur du transistor T. On veut que le circuit puisse fonctionner, que la sortie 10 soit reliée à la charge R par l'intermédiaire d'un condensateur de couplage C ou qu'elle soit reliée directement (ou par l'intermédiaire d'une charge adaptatrice) à la charge R. Selon la présente invention, il est prévu de comparer le courant de collecteur du transistor T à un courant de référence et de mettre en action le générateur de courant I seulement quand le courant collecteur est inférieur ou sensiblement égal à ce courant I. Dès que ce courant de collecteur devient supérieur au courant I, le circuit comparateur 11 inhibe l'action du générateur de courant I.

Si l'on voulait comparer directement le courant de collecteur à un courant de référence de valeur égale au courant alternatif, cela entraînerait la nécessité de prévoir une source de courant de référence auxiliaire de valeur sensiblement égale à I, c'est-à-dire de consommer de toute manière dans le circuit un courant de référence sensiblement égal à I et l'avantage de diminution de consommation selon la présente invention serait perdu. Ainsi, comme on le verra ci-après, la présente invention prévoit de comparer non pas directement le courant de collecteur à un courant de référence, mais seulement de comparer une fraction prédéterminée de ce courant de collecteur à un courant de référence de valeur plus faible.

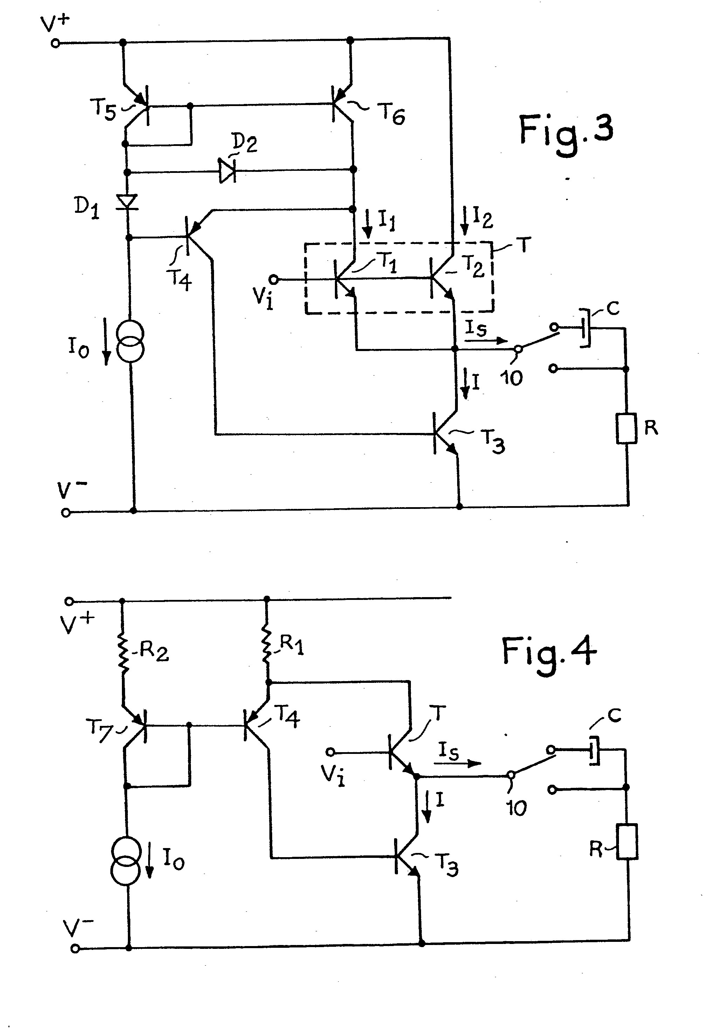

La figure 3 représente un premier mode de réalisation de la présente invention. Le circuit émetteur-suiveur T est constitué non pas d'un transistor unique mais d'un ensemble de deux transistors T1 et T2 dont les bases et les émetteurs sont interconnectés. Le transistor T1 a une surface d'émetteur n fois plus petite que celle du transistor T2. Ainsi, ce transistor sera traversé par un courant n fois plus petit que le transistor T2. Le circuit générateur de courant est réalisé sous forme d'un transitor T3 relié par son collecteur aux émetteurs des transistors T1 et T2 et par son émetteur à la tension de référence. La base de ce transistor T3 est polarisée par un transistor T4.

Le circuit comprend en outre un miroir de courant constitué de deux transistors T5 et T6 dont les émetteurs (ainsi que le collecteur du transistor T2) sont reliés à la tension d'alimentation positive V+. Les bases de ces transistors T5 et T6 sont interconnectées et la base du transistor T5 est connectée à son collecteur. Le collecteur du transistor T6 est relié au collecteur du transistor T1 et à l'émetteur du transistor T4. Le collecteur du transistor T5 est relié par une première diode D1 à la base du transistor T4 et par une deuxième diode D2 au collecteur du transistor T6. La base du transistor T4 est reliée par une source de courant $I_0$ à la tension de référence.

Le fonctionnement de ce circuit est le suivant.

Quand la borne de sortie 10 est couplée capacitivement à

6

la charge R, le courant continu de sortie $I_s$ est nul. Les courants $I_1$ et $I_2$ dans les collecteurs des transistors T1 et T2 sont donc tels que $I_1 + I_2 = I$, I étant le courant traversant le transistor T3. En raison de la configuration géométrique des transistors T1 et T2, $I_1 = n\ I_2$. En première approximation, si n est suffisamment grand, on a $I = n\ I_1$. Pour fixer cette valeur I à une valeur convenable, il convient de choisir convenablement la valeur du courant de la source de courant $I_o$ qui est alors égale à $I_1$ en négligeant les courants de base des transistors T3 et T4. On a alors $I_1 \simeq I_0$ et le transistor T3 est conducteur avec un courant $I \simeq n\ I_0$.

Si maintenant, on couple la borne 10 directement sur une charge résistive R, un courant continu $I_s$ circulera en sortie. On tendra donc à extraire des émetteurs des transistors T1 et T2 un courant $I + I_s$. Le courant $I_1$ tendra à être égal à :

$$\frac{I\ +\ I_s}{n}\ .$$

Ce courant correspondra donc d'une part au courant traversant le transistor T6, d'autre part à un courant passant par le transistor T5 et la diode D2. Mais alors, le transistor T4 se bloque et le courant de base n'est plus fourni au transistor T3. Le courant I tend alors vers zéro et seul le courant $I_s$ circule. On a donc bien obtenu le résultat souhaité, qui consiste à supprimer le courant de polarisation I quand un couplage direct sur charge résistive est effectué.

Dans le fonctionnement décrit précédemment du circuit selon l'invention, on a décrit un fonctionnement par tout ou rien dès .qu'apparaît un courant de sortie $I_s$. En fait, l'inhibition du courant I est progressive et devient totale seulement quand le courant $I_s$ dépasse un certain seuil. On notera également que le transistor T4 peut être considéré comme ayant un rôle de comparateur ente le courant de collecteur du transistor T1 qui correspond à une fraction du courant de collecteur de l'ensemble des transistors montés en émetteur-suiveur T1, T2 et un courant de

référence $I_0$.

La figure 4 représente un deuxième mode de réalisation de la présente invention. On y retrouve le transistor T connecté en émetteur-suiveur, sa borne de commande $V_1$, sa borne de sortie 10, le condensateur de couplage C et la charge résistive R, ainsi que le transistor T3 servant de générateur de courant et un transistor T4 servant de commande de ce générateur de courant T3 et de comparateur. Le collecteur du transistor T est connecté à la source d'alimentation positive par l'intermédiaire d'une première résistance R1. Cette borne de collecteur est également reliée à la base du transistor T3 par l'intermédiaire d'un transistor T4. La base du transistor T4 est connectée à la base et au collecteur d'un transistor T7 dont l'émetteur est relié à la borne d'alimentation positive par l'intermédiaire d'une résistance R2 de valeur n fois supérieure à celle de la résistance R1. Le collecteur du transistor T7 est connecté à la tension de référence $V^-$ par l'intermédiaire d'une source de courant $I_0$. Dans le cas d'un couplage capacitif, quand le courant continu $I_s$ vers la borne de sortie 10 est nul, l'intensité I du courant traversant le transistor T3 est sensiblement égale à $nI_0$. Par contre, en cas de couplage résistif direct sur la charge R, le courant $I_s$ s'établit à une certaine valeur et le courant de base vers le transistor T3 s'annule d'où il résulte que le courant I vers ce transistor T3 devient très faible. On obtient bien là aussi les buts recherchés par la présente invention.

Le circuit selon la présente invention permet d'obtenir un étage de sortie pouvant fonctionner aussi bien en couplage capacitif qu'en couplage direct et à dissipation de puissance limitée en cas de couplage direct. Il pourra par exemple s'appliquer à des circuits d'amplification vidéo, pouvant recevoir des signaux vidéo interne ou externe et fonctionner vers des sorties interne ou externe. Supposons un étage de sortie pouvant fonctionner sur charge adaptée de 75 ohms (charge réelle de 150 ohms) avec une tension alternative de valeur de crête de 3 volts, soit en couplage capacitif, soit en couplage direct avec une tension continue de 4 volts. Pour permettre d'obtenir la tension

8

crête de 3 volts en cas de couplage capacitif, il faudra prévoir un courant de polarisation I de l'étage de sortie égal à 3 volts que divisent 150 ohms, soit 20 milliampères. Ce courant étant fourni par une tension d'alimentation de 12 volts, ceci correspond à une consommation de 240 milliwatts. Dans le cas où l'on opère en couplage continu, le courant continu $I_s$ consommé est de 4 volts que divisent 150 ohms, soit 27 milliampères. Ce courant est consommé sous une tension de 12 volts − 4 volts, soit 8 volts, ce qui fournit une consommation de 210 milliwatts. Si l'on maintenait la tension de polarisation nécessaire en cas de couplage capacitif, on aurait une consommation propre d'étage de sortie de l'ordre de 240 + 210 = 450 milliwatts. Selon la présente invention, cette consommation est limitée à seulement 210 milliwatts. Ces valeurs sont loin d'être négligeables dans un circuit intégré dont la consommation peut par exemple être par ailleurs pour les autres étages d'environ 450 milliwatts. En cas de couplage continu, on a selon la présente invention une consommation totale de 450 + 210 milliwatts, soit 660 milliwatts, alors que, si l'on n'avait pas utilisé le circuit d'inhibition de polarisation, on aurait une consommation supplémentaire de 240 milliwatts, soit une consommation totale de 450 + 210 + 240 = 900 milliwatts. Comme le notera l'homme de l'art, cette diminution de consommation est très importante, l'économie de puissance étant un problème primordial dans la conception des circuits intégrés.

La présente invention n'est pas limitée aux modes de réalisation qui ont été explicitement décrits ; elle en englobe les diverses variantes et généralisations incluses dans le domaine des revendications ci-après.

9

REVENDICATIONS.

1. Etage de sortie à circuit émetteur-suiveur (T) polarisé par un générateur de courant, caractérisé en ce qu'il comprend des moyens (11) pour interrompre l'action du générateur de courant (I) quand le circuit de charge est couplé de façon résistive et extrait un courant continu de valeur supérieure à un seuil prédéterminé.

2. Etage de sortie selon la revendication 1, caractérisé en ce que les moyens pour interrompre l'action du générateur de courant comprennent des moyens pour comparer un courant de référence ($I_0$) à un courant divisé ($I_1$) se trouvant dans un rapport de division déterminé par rapport audit courant continu dans le circuit de charge et pour commander le générateur de courant (I) quand le courant de référence est supérieur au courant divisé.

3. Etage de sortie selon la revendication 2, caractérisé en ce que le générateur de courant (I) est constitué d'un troisième transistor (T3) en série avec l'émetteur du circuit émetteur-suiveur (T), la base de ce troisième transistor recevant un courant par l'intermédiaire d'un quatrième transistor comparateur (T4) seulement quand celui-ci est à l'état passant.

4. Etage de sortie selon la revendication 3, caractérisé en ce que le courant divisé est obtenu du fait que le circuit émetteur-suiveur est constitué d'un premier (T1) et d'un second (T2) transistor à bases communes et émetteurs communs, la surface d'émetteur du premier transistor étant n fois plus petite que celle du second, d'où il résulte que le courant de collecteur du premier transistor reflète le courant d'émetteur de l'ensemble des premier et second transistors avec un facteur diviseur de n.

5. Etage de sortie selon la revendication 4, caractérisé en ce qu'il comprend en outre des cinquième (T5) et sixième (T6) transistors connectés en miroir de courant, leurs émetteurs étant reliés à la borne d'alimentation positive, de même que le collecteur du deuxième transistor (T2) ; le collecteur du sixième tran-

10

sistor étant connecté au collecteur du premier transistor (T1), à l'émetteur du quatrième transistor et à la cathode d'une première diode (D1) ; le collecteur du cinquième transistor étant connecté à sa base, à l'anode de la première diode et à l'anode d'une deuxième diode (D2) ; la cathode de la deuxième diode étant reliée à la base du quatrième transistor et à une source de courant de référence ($I_0$).

6. Etage de sortie selon la revendication 3 dans lequel le circuit émetteur-suiveur est constitué d'un transistor unique (T), caractérisé en ce que le collecteur du transistor à émetteur-suiveur est connecté par l'intermédiaire d'une première résistance (R1) à une borne d'alimentation positive et à la base du troisième transistor (T3) par l'intermédiaire d'un quatrième transistor (T4), ce circuit comprenant en outre un autre transistor (T7) dont l'émetteur est relié à la borne d'alimentation positive par une seconde résistance (R2) de valeur n fois plus grande que la première résistance, dont le collecteur est relié à la base et à une source de courant ($I_0$) de valeur prédéterminée, et dont la base est reliée à celle du quatrième transistor.

Fig.1

Fig.2

0045691

Fig.3

Fig.4